# EUROPÄISCHE PATENTANMELDUNG

(11) **EP 2 192 420 A1**
(43) Veröffentlichungstag der Anmeldung: **02.06.2010**
(21) Anmeldenummer: 08075911.1
(22) Anmeldetag: 28.11.2008
(51) Int. Cl.: G01S 7/481, G01V 8/12, H01L 25/16, H01L 31/12

(54) **Optische Sende- und Empfangs-Baueinheit und Sensor mit einer solchen**

(71) Anmelder: Siemens Aktiengesellschaft, 80333 München (DE)
(72) Erfinder: Beier, Axel, 16552 Schildow (DE); Reznik, Daniel, Dr., 13503 Berlin (DE)

(57) **Zusammenfassung**

Die Erfindung betrifft eine optische Sende- und Empfangs-Baueinheit (26), mit einem optischen Sender (24) und einem optischen Empfänger (25) und zugehörigen Optiken (27, 28). Erfindungsgemäß ist vorgesehen, die Baueinheit (26) als dreidimensionalen Schaltungsträger auszuführen, wobei die zur Kontaktierung dienenden Leiterbahnen (32) um verschiedene Gehäuseseiten herumgeführt werden und in Kontaktflächen (33) einer Montageseite (38) enden. Daher kann der dreidimensionale Schaltungsträger in nicht dargestellter Weise durch Oberflächenmontage, beispielsweise in einem Sensor, verbaut werden, der auch beansprucht wird. Die für die optische Montage erforderliche Fertigungsgenauigkeit zur Ausrichtung der einzelnen optischen Komponenten muss vorteilhaft nur bei der Montage in dem dreidimensionalen Schaltungsträger berücksichtigt werden. Die Endmontage des Sensors kann mit den wesentlich geringeren Genauigkeitsanforderungen der Elektronikmontage erfolgen, ohne dass nach Endmontage des optischen Sensors noch eine optische Justage erforderlich ist. Es handelt sich daher um eine wirtschaftliche Lösung.

## Beschreibung

Die Erfindung betrifft eine optische Sende- und Empfangs-Baueinheit, die folgende Elemente aufweist. Zunächst ist ein optischer Sender vorgesehen mit einer ersten Optik zur Beeinflussung dieses Sendesignals. Außerdem ist ein optischer Empfänger vorgesehen, der eine zweite Optik zur Beeinflussung des Empfängersignals aufweist. Außerdem weist die Baueinheit ein Gehäuse auf, in dem der optische Sender, der optische Empfänger, die erste Optik und die zweite Optik zueinander ausgerichtet fixiert sind.

Eine optische Sende- und Empfangs-Baueinheit der eingangs genannten Art ist beispielsweise in der DE 10 2006 016 913 A1 beschrieben. Dieses wird als optischer Sensor verwendet, wobei ein Gehäuse vorgesehen ist, in dem ein optischer Sender und ein optischer Empfänger montiert sind. Für den Sender und den Empfänger gibt es weiterhin jeweils eine Optik, wobei eine der beiden Optiken nach erfolgter Montage des Sensors noch beweglich in der Konfiguration gelagert ist. Um eine einwandfreie optische Ausrichtung zueinander zu gewährleisten, kann diese bewegliche Optik zur Eliminierung toleranzbedingter Lageabweichungen justiert werden. Sobald die geforderte optische Funktionsweise des Sensors gewährleistet ist, wird das bewegliche optische Element mittels einer Vergussmasse endgültig fixiert.

Zusammenfassend ist festzustellen, dass der Sensor gemäß der DE 10 2006 016 913 A1 eine für die optische Funktion hinreichende Fertigungs- und Montagegenauigkeit bei der Herstellung erfordert. Die im Rahmen der Optikmontage auftretenden Fertigungs- und Montagetoleranzen müssen dann durch den nachgelagerten Justagevorgang ausgeglichen werden.

Die Aufgabe der Erfindung besteht darin, eine optische Sende- und Empfangs-Baueinheit bzw. einen optischen Sensor anzugeben, der vergleichsweise einfach zu fertigen und zu montieren ist und dabei ein vergleichsweise hohes Maß an optischer Präzision ermöglicht.

Diese Aufgabe wird erfindungsgemäß mit der eingangs angegeben optischen Sende- und Empfangs-Baueinheit dadurch gelöst, dass das Gehäuse als dreidimensionaler Schaltungsträger ausgeführt ist. Im Inneren dieses Schaltungsträgers sind der optische Sender und der optische Empfänger elektrisch kontaktiert und damit fixiert. Für den optischen Sender und den optischen Empfänger werden ungehäuste Chipbauteile verwendet. Dies hat den Vorteil, dass diese durch die elektrische Kontaktierung auch optisch ausgerichtet werden können, da die elektrischen Kontaktflächen dieser Bauelemente gleichzeitig mit den optischen Funktionselementen gefertigt werden. Anders als bei gehäusten Sendern und Empfängern, bei denen bauartbedingt bereits vor der Montage in der Sende- und Empfangs-Baueinheit eine Maßabweichung zwischen den Kontakten am Bauelement-Gehäuse und dem optisch aktiven Element auftreten kann, lässt sich dies bei den erfindungsgemäß verwendeten ungehäusten Bauteilen ausschließen.

Weiterhin sind erfindungsgemäß die Leiterbahnen, die zur Kontaktierung des optischen Senders und des optischen Empfängers dienen, aus dem Inneren des Schaltungsträgers nach außen geführt. Damit ist es möglich, die erfindungsgemäße Baueinheit in einer Umgebung, die die Infrastruktur für einen vollständigen Sensor zur Verfügung stellt, zu montieren und elektrisch zu kontaktieren. Da der dreidimensionale Schaltungsträger auch die erste und die zweite Optik aufweist, ist es erfindungsgemäß daher möglich, die optischen Funktionselemente, die mit einer vergleichsweise hohen Genauigkeit montiert werden müssen, hochgenau in dem dreidimensionalen Schaltungsträger zu fixieren und diesen dann mit einer geringeren Montagegenauigkeit, die für die Elektronikmontage ausreicht, in der Umgebung, beispielsweise einer Leiterplatte für einen Sensor zu montieren. In diesem Fertigungsschritt kann auch die elektrische Kontaktierung mit weiteren für den Sensor notwendigen Bauteilen erfolgen.

So gelangt man erfindungsgemäß zu einem optischen Sensor mit einem Außengehäuse, in dem ein optischer Sender, ein optischer Empfänger eine Steuereinheit und eine Auswerteeinheit vorgesehen sein müssen. Der optische Sender und der optische Empfänger sind vorteilhaft zur erfindungsgemäßen optischen Sende- und Empfangs-Baueinheit zusammengefasst, wodurch sich die bereits beschriebenen Vorteile bei der Endmontage des Sensors ergeben. Die hochgenau zu fertigende Sende- und Empfangs-Baueinheit kann daher in hoher Stückzahl gefertigt werden, so dass sich die mit der geforderten Montagegenauigkeit verbundenen Kosten auf eine vergleichsweise hohe Stückzahl verteilen. Dann kann die optische Baugruppe standardmäßig in unterschiedlichen optischen Sensoren oder auch anderen optischen Anwendungen verbaut werden, wobei diese Anwendungen (Sensoren) nach der Endmontage vorteilhaft keiner optischen Justage mehr bedürfen.

Die optische Sende- und Empfangs-Baueinheit ist bevorzugt für eine Oberflächenmontage vorbereitet. Demgemäß kann sie beispielsweise zusammen mit einer Auswerteeinheit und einer Steuereinheit auf einer Leiterplatte montiert und dann in das Außengehäuse eines optischen Sensors eingebaut werden. Die Baueinheit kann dabei bezüglich der Oberfläche (Leiterplatte), auf der sie montiert werden soll, mit einer optischen Strahlrichtung parallel oder senkrecht zu dieser Oberfläche erfolgen. Von der Einbaulage abhängig ist die Art und Lage der Kontaktierung (hierzu im Folgenden mehr).

Gemäß einer vorteilhaften Ausgestaltung der Erfindung ist vorgesehen, dass die ungehäusten Bauteile als sogenannte Bottom Emitter ausgeführt sind. Als Bottom Emitter bezeichnet man ungehäuste Chipbauteile, deren elektrische Kontakte auf der der optischen Seite gegenüberliegenden Seite liegen. Die optische Seite ist im Falle des Senders diejenige Seite, von der das optische Signal abgestrahlt wird. Im Falle des optischen Empfängers ist es diejenige Seite, die das optische Signal empfängt. Die Bauform als Bottom Emitter hat den Vorteil, dass die Bauteile auf den dreidimensionalen Schaltungsträger aufgesetzt werden können, ohne dass unter ihnen eine Durchgangsöffnung für das optische Signal vorgesehen werden muss. Dies vereinfacht vorteilhaft die Fertigung.

Gemäß einer anderen Ausgestaltung der Erfindung ist vorgesehen, dass der dreidimensionale Schaltungsträger als MID-Bauteil ausgeführt ist. Diese Abkürzung steht für Molded Interconnect Device. Es handelt sich dabei um elektrische Schaltungsträger, deren elektrische Verbindungen (interconnect) bei einem urformtechnischen Prozess in das zu erzeugende Bauteil integriert werden. Hierdurch lassen sich vorteilhaft sehr kostengünstige Bauteile erzeugen. Beispielsweise kann ein Gerüst aus Kontaktflächen und Leiterbahnen (auch leadframe genannt) mit Kunststoff umspritzt werden.

Eine weitere Ausgestaltung der Erfindung erhält man, wenn die erste Optik und/oder die zweite Optik in ein Deckelbauteil integriert sind, das eine Einbauöffnung für den optischen Sender und/oder den optischen Empfänger verschließt. Der dreidimensionale Schaltungsträger kann vorteilhaft so gestaltet werden, dass eine vergleichsweise große Öffnung in das Innere der ausgebildeten Gehäusestruktur entsteht. Dies vereinfacht einmal die Fertigung des dreidimensionalen Schaltungsträgers, der vorteilhaft wenig Hinterschneidungen aufweisen muss. Außerdem wird durch die großen Einbauöffnungen die Montage des optischen Senders und des optischen Empfängers erleichtert. Anschließend kann der Deckel aufgesetzt werden, um einen genügenden Schutz für den optischen Sender und den optischen Empfänger zu gewährleisten, wobei die Integration der ersten und/oder zweiten Optik in den Deckel bewirkt, dass hierbei der Fertigungs- und Montageaufwand nicht steigt. Alternativ kann ein Deckel vorgesehen werden, der sowohl die erste als auch die zweite Optik beinhaltet. Denkbar ist es auch, dass zwei Deckel mit jeweils einer Optik verwendet werden. Besonders vorteilhaft ist es, wenn das Deckbauteil einstückig aus einem optischen Medium hergestellt ist, so dass die erste Optik und die zweite Optik aus dem Deckelmaterial bestehen können. Hierdurch wird eine besonders einfache Fertigung ermöglicht. Als Optik zur Beeinflussung der Signale (Sendersignal und Empfängersignal) werden bevorzugt Sammellinsen verwendet, die auch als Fesnel-Linsen ausgeführt sein können. Allerdings sind auch andere Möglichkeiten einer Beeinflussung der Signale denkbar, beispielsweise eine wellenlängenselektive Filterung, so dass nur Licht in der Wellenlänge des Messlichtes auf das Empfangselement trifft.

Weiterhin ist es vorteilhaft, wenn im Inneren des Gehäuses eine Trennwand zwischen dem Sender und dem Empfänger vorgesehen ist. Hierdurch kann vorteilhaft erreicht werden, dass sich diese beiden optischen Bauelemente optisch nicht beeinflussen, d. h. dass Licht von dem Sender direkt zum Empfänger gelangt, ohne aus der Baueinheit ausgekoppelt und wieder eingekoppelt worden zu sein. Hierdurch lässt sich vorteilhaft die Güte des empfangenden Messsignals verbessern. Auch ist es möglich, die Trennwand mit einer Metallisierung, beispielsweise einer Metallschicht, zu versehen. Hierdurch lässt sich vorteilhaft eine elektrische Abschirmung herstellen, die bewirkt, dass sich der optische Sender und der optische Empfänger, bei denen es sich um elektrooptische Wandler handelt, elektrisch nicht beeinflussen. Hierdurch kann eine weitere Quelle für Messfehler eliminiert werden.

Um vorteilhaft eine definierte Einbaulage der Baueinheit zu erhalten, kann vorgesehen werden, dass eine Montageseite am dreidimensionalen Schalter schaltungsträgerfrei vorgesehen ist, auf der die Leiterbahnen zu Kontaktflächen für Lotdepots geführt sind. Diese Kontaktflächen sind bei dem Einbau durch Oberflächenmontage dann der Oberfläche des Substrates zugekehrt. Hierdurch wird vorteilhaft eine sogenannte Flip-Chip-Montage ermöglicht. Die Kontaktflächen oder das Substrat können mit Lotkügelchen versehen werden, die bei dem Prozess der Oberflächenmontage aufgeschmolzen werden und auf diese Weise die elektrische Kontaktierung und die mechanische Fixierung der Baueinheit gewährleisten.

Besonders vorteilhaft ist es, wenn der Schaltungsträger zwei Montageseiten mit Kontaktflächen aufweist, die senkrecht zueinander stehen. Diese können so ausgerichtet sein, dass die Strahlrichtung des ausgesendeten bzw. empfangenen optischen Signals gerade senkrecht oder parallel zur Oberfläche, auf der die Baueinheit montiert werden soll, liegt. Dies sind die bevorzugten Einbauformen für optische Sende- und Empfangs-Baueinheiten, so dass unterschiedliche Sensorbauformen mit dem gleichen standardisierten Bauteil realisiert werden können.

Weiterhin kann vorteilhaft vorgesehen werden, dass auf der Montageseite oder den Montageseiten zusätzlich zu den Kontaktflächen metallische Flächen ohne elektrischen Anschluss angeordnet sind. Diese metallischen Flächen können ebenfalls mit Lotdepots versehen werden, welche allerdings keiner elektrischen Kontaktierung, sondern lediglich einer mechanischen Fixierung der Baueinheit dienen. Hierdurch kann die mechanische Stabilität der montierten Baueinheit auf der Oberfläche verbessert werden. Gleichzeitig werden die elektrischen Kontaktstellen entlastet, so dass es zu einer höheren Bauteilzuverlässigkeit kommt. Denn eine mechanische Beanspruchung von elektrischen Lotkontakten kann dazu führen, dass diese versagen.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben.

Es zeigen:
- Figur 1: den schematischen Schnitt durch ein Ausführungsbeispiel des erfindungsgemäßen Sensors und
- Figur 2 und 3: perspektivische Ansichten eines Ausführungsbeispiels der erfindungsgemäßen Sende- und Empfangs-Baueinheit.

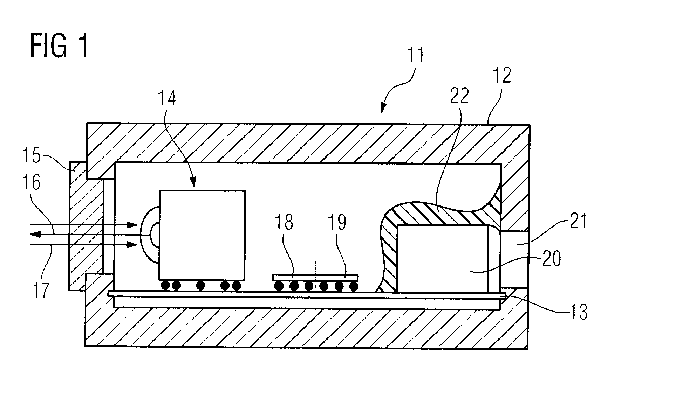

Ein Sensor 11 gemäß Figur 1 weist ein Außengehäuse 12 auf, in das eine Leiterplatte 13 eingesetzt wurde. Diese Leiterplatte weist eine Sende- und Empfangs-Baueinheit 14 auf, welche derart vor einem Fenster 15 in der Wand des Außengehäuses 12 positioniert ist, das ein Sendersignal 16 und ein Empfangssignal 17 durch das Fenster 15 mit der Baueinheit 14 kommunizieren können. Über die Leiterplatte 13 ist die Baueinheit 14 mit einem Chip kontaktiert, welcher eine Steuereinheit 18 und eine Auswerteeinheit 19 in sich vereint. Die Steuereinheit hat die Aufgabe einer Ansteuerung eines nicht näher dargestellten Senders in der Baueinheit, während die Auswerteeinheit das Signal eines nicht näher dargestellten Empfängers verarbeitet und auf diese Weise einen Messwert generiert.

Der optische Sensor 11 gemäß Figur 1 kann zu unterschiedlichen Aufgaben herangezogen werden. Beispielsweise lässt sich mit einem solchen Sensor eine Lichtschranke realisieren. Eine andere Anwendung liegt in der Verwendung des Sensors als Abstandssensor. Je nach Einsatzzweck sind die Steuereinheit und die Auswerteeinheit in geeigneter Weise zu konfigurieren, um Messwerte für den vorliegenden Anwendungsfall zu generieren. Die Messwerte sowie eine eventuelle Energieversorgung kann durch einen Steckverbinder 20 realisiert werden, der ebenfalls auf der Leiterplatte 13 montiert ist, wobei eine hermetische Versiegelung einer Steckeröffnung 21 im Außengehäuse 12 durch eine Dichtmasse 22 erfolgt.

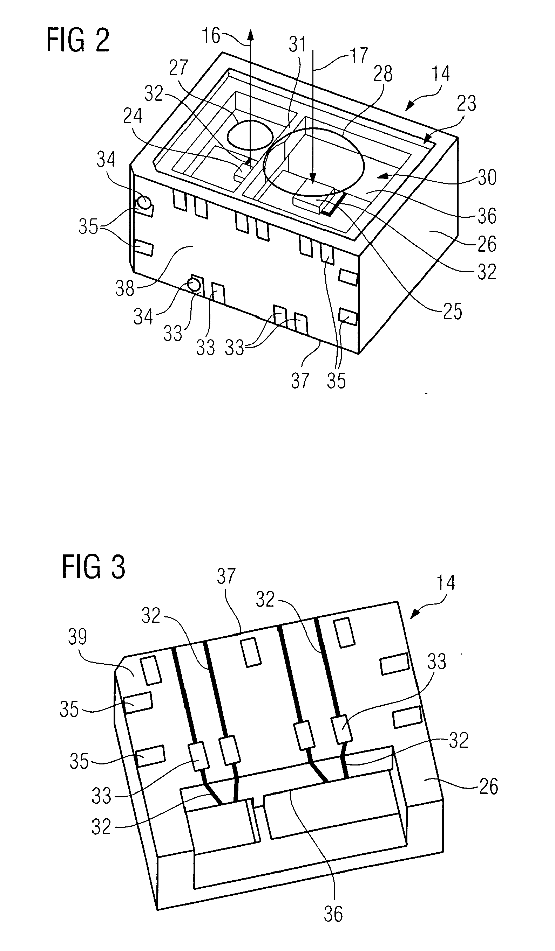

Die Figuren 2 und 3 stellen verschiedene isometrische Ansichten eines Ausführungsbeispiels der erfindungsgemäßen Sende- und Empfangseinheit dar, wie sie auch in einem Sensor gemäß Figur 1 verbaut werden könnte.

Die Figur 2 lässt einen Blick durch ein transparentes Deckelbauteil 23 in das Gehäuseinnere zu, wobei in diesem ein Sender 24 und ein Empfänger 25 angeordnet sind. An der Richtung des Sendersignals 16 und des Empfängersignals 17 lässt sich leicht erkennen, dass es sich bei dem Sender 24 und dem Empfänger 25 um Bottom Emitter handelt, welche als ungehäuste Chipbauteile auf das als dreidimensionaler Schaltungsträger 26 ausgeführte Gehäuse gesetzt sind.

In dem Deckelbauteil ist eine erste Optik 27 und eine zweite Optik 28 in Form von Sammellinsen einstückig ausgebildet, wobei der Deckel passgenau in eine Aufnahme des dreidimensionalen Schaltungsträgers 26 eingesetzt ist. Durch eine positionsgenaue Montage des Senders 24 und Empfängers 25 und die passgenaue Einfügung des genau gefertigten Deckelbauteils 23 erfolgt eine für die optische Übertragung von Signalen ausreichend genaue Ausrichtung der den optischen Strahlengang beeinflussenden optischen Komponenten (d. h. des Senders 24, des Empfängers 25, der ersten Optik 27 und der zweiten Optik 28, wie durch den Strahlengang des Sendersignals 16 und des Empfängersignals 17 angedeutet).

Die unter dem Deckelbauteil 23 liegende Einbauöffnung 30 für den Sender 24 und den Empfänger 25 ist durch eine Trennwand 31 geteilt, welche das Innere des Gehäuses, also den Einbauraum für den Sender 24 und den Empfänger 25 in zwei Abteilungen unterteilt. Hierdurch ist eine optische Abschirmung dieser beiden Chipbauteile gewährleistet. Wird die Trennwand 31 in nicht näher dargestellter Weise metallisiert, so ist auch eine elektrische Abschirmung zwischen den beiden Chipbauteilen gewährleistet.

Von dem Sender 24 und dem Empfänger 25 führen auf dem dreidimensionalen Schaltungsträger 26 Leiterbahnen 32 weg, die in Kontaktflächen 33 für eine Montage des dreidimensionalen Schaltungsträgers in SMT-Technologie geeignet sind. Zu diesem Zweck können auf den Kontaktflächen 33 Lotkugeln 34 aufgesetzt werden, von denen eine exemplarisch dargestellt ist. Diese Lotkugeln schmelzen in einem Reflow-Lötprozess auf, wodurch eine elektrische Kontaktierung sowie mechanische Fixierung des dreidimensionalen Schaltungsträgers 26 beispielsweise auf einer Leiterplatte erfolgt. Um die mechanische Anbindung des dreidimensionalen Schaltungsträgers 26 zu verbessern, sind außerdem weitere metallische Flächen 35 vorgesehen, die nicht elektrisch mit einem Bauelement kontaktiert sind, sondern lediglich der Aufnahme von weiteren Lotkugeln 34 dienen, so dass nach erfolgter Montage des dreidimensionalen Schaltungsträgers 26 eine Vielzahl metallischer Fixierungspunkte entsteht.

Der Verlauf der Leiterbahnen 32 auf dem dreidimensionalen Schaltungsträger kann durch einen Vergleich der Figuren 2 und 3 verstanden werden, auch wenn es sich hierbei nur um zwei Ansichten dieses dreidimensionalen Körpers handelt. Zum besseren Verständnis sind die Kanten 36 und 37 in den Figuren 2 und 3 gekennzeichnet, wobei es sich hierbei jeweils um dieselbe Kante des dreidimensionalen Schaltungsträgers 26 in der betreffenden Ansicht handelt. Um diese Kanten herum werden die Leiterbahnen nämlich geführt. Dabei entsteht eine erste Montageseite 38 und eine zweite Montageseite 39, wobei die Montageseiten für die SMT-Montage dienen und insofern der dreidimensionale Schaltungsträger mit einer Abstrahlrichtung senkrecht bzw. parallel zur Oberfläche des Substratbauteils verbaut werden kann.

Die Leiterbahnen beginnen bei dem Sender 24 und dem Empfänger 25 und verlaufen auf der jeweiligen Fläche, auf die diese Bauteile aufgesetzt sind. Sie laufen weiterhin über die Kante 36 und eine weitere Kante zur Montageseite 39, wo sie sich zu den Kontaktflächen 33 erweitern. Außerdem verlaufen sie auf der Montageseite 39 auch zur Kante 37 hin, wobei sich an die Kante 37 auf der benachbarten Montageseite 38 gleich die anderen Kontaktflächen 33 anschließen und auf diese Weise ebenfalls elektrisch leitend mit dem Sender 24 und dem Empfänger 25 verbunden sind.

## Patentansprüche

1. Optische Sende- und Empfangs-Baueinheit, aufweisend
• einen optischen Sender (24) mit einer ersten Optik (27) zur Beeinflussung des Sendesignals,
• einem optischen Empfänger (25) mit einer zweiten Optik (28) zur Beeinflussung des Empfängersignals und
• einem Gehäuse, in dem der optische Sender (24), der optische Empfänger (25), die erste Optik (27) und die zweite Optik (28) zueinander ausgerichtet fixiert sind,
**dadurch gekennzeichnet,**
**dass** das Gehäuse als dreidimensionaler Schaltungsträger (26) ausgeführt ist,
• in dessen Inneren der als ungehäustes Chipbauteil ausgeführte optische Sender (24) und der als ungehäustes Chipbauteil ausgeführte optische Empfänger (25) elektrisch konaktiert sind, und
• bei dem Leiterbahnen (32) zur Kontaktierung des optischen Senders (24) und des optischen Empfängers (25) nach außen geführt sind.

2. Baueinheit nach Anspruch 1,
**dadurch gekennzeichnet,**
**dass** die ungehäusten Chipbauteile als Bottom Emitter ausgebildet sind.

3. Baueinheit nach einem der voranstehenden Ansprüche,
**dadurch gekennzeichnet,**
**dass** der dreidimensionale Schaltungsträger (26) als MID-Bauteil ausgebildet ist.

4. Baueinheit nach einem der voranstehenden Ansprüche,
**dadurch gekennzeichnet,**
**dass** die erste Optik (27) und/oder die zweite Optik (28) in ein Deckelbauteil (23) integriert sind, dass eine Einbauöffnung (30) für den optischen Sender (24) und/oder den optischen Empfänger (25) verschließt.

5. Baueinheit nach Anspruch 4,
**dadurch gekennzeichnet,**
**dass** das Deckelbauteil (23) einstückig aus einem optischen Medium hergestellt ist.

6. Baueinheit nach einem der voranstehenden Ansprüche,
**dadurch gekennzeichnet,**
**dass** im Inneren des Gehäuses eine Trennwand (31) zwischen dem Sender (24) und dem Empfänger (27) vorgesehen ist.

7. Baueinheit nach einem der voranstehenden Ansprüche,
**dadurch gekennzeichnet,**
**dass** eine Montageseite am dreidimensionalen Schaltungsträger vorgesehen ist, auf der die Leiterbahnen (32) zu Kontaktflächen (33) für Lotdepots geführt sind.

8. Baueinheit nach Anspruch 7,
**dadurch gekennzeichnet,**
**dass** der Schaltungsträger zwei Montageseiten mit Kontaktflächen (33) aufweist, die senkrecht zueinander stehen.

9. Baueinheit nach einem der Ansprüche 7 oder 8,
**dadurch gekennzeichnet,**
**dass** auf der Montageseite oder den Montageseiten zusätzlich zu den Kontaktflächen (33) metallische Flächen (35) ohne elektrischen Anschluss angeordnet sind.

10. Optischer Sensor mit einem Außengehäuse (12), in dem ein optischer Sender, ein optischer Empfänger, eine Steuereinheit (18) und eine Auswerteeinheit (19) vorgesehen sind,
**dadurch gekennzeichnet,**
**dass** der optische Sender und der optische Empfänger als optische Sende- und Empfangs-Baueinheit (14) gemäß einem der voranstehenden Ansprüche ausgeführt ist.

11. Optischer Sensor nach Anspruch 10,
**dadurch gekennzeichnet,**
**dass** die optische Sende- und Empfangs-Baueinheit (14), die Steuereinheit (18) und die Auswerteeinheit (19) gemeinsam auf einer Leiterplatte (13) montiert sind.
